# DEMANDE DE BREVET EUROPEEN

(11) **EP 3 026 331 A1**
(43) Date de publication de la demande: **01.06.2016**
(21) Numéro de dépôt: 15192837.1
(22) Date de dépôt: 03.11.2015
(51) Int. Cl.: F21S 8/10, G02B 26/08, B81B 3/00, H01L 41/09

(54) **SYSTÈME D'ÉCLAIRAGE POUR VÉHICULE AUTOMOBILE À BALAYAGE DE FAISCEAU LUMINEUX**

(30) Priorité: 27.11.2014 FR 1461587
(71) Demandeur: VALEO VISION, 93012 Bobigny Cedex (FR)
(72) Inventeur: ALBOU, Pierre, 75013 PARIS (FR); GODBILLON, Vincent, 75011 PARIS (FR); PUENTE, Jean-Claude, 93190 LIVRY GARGAN (FR)

(57) **Abrégé**

La présente invention concerne un système d'éclairage (10) qui comprend une source de lumière (12) apte à produire un faisceau lumineux (L), et des moyens (14) pour balayer le faisceau lumineux comportant au moins un corps réfléchissant oscillant (18) pour la déviation de la trajectoire du faisceau.

Selon l'invention, le corps réfléchissant oscillant (18) est manoeuvré par les déformations d'un organe de manoeuvre piézoélectrique (22). Les moyens (14) pour balayer le faisceau lumineux (L) comportent de plus des moyens optiques (28) d'amplification de la déviation de la trajectoire du faisceau lumineux, placés en aval du corps réfléchissant (18) en considérant le sens de propagation du faisceau lumineux (L).

## Description

La présente invention concerne le domaine technique des systèmes d'éclairage pour véhicule automobile. Plus particulièrement, l'invention concerne un système d'éclairage formant un projecteur pour véhicule automobile.

Un projecteur de véhicule automobile a pour principale fonction d'éclairer la route, et comprend divers systèmes optiques et sources de lumière.

Il est connu de faire fonctionner un projecteur selon deux modes.

Le premier mode, communément appelé « feu de croisement », produit un éclairage légèrement dévié vers le bas afin d'éclairer la route à l'avant du véhicule sur environ une cinquantaine de mètres et de ne pas éblouir d'éventuels automobilistes qui circuleraient en sens inverse sur une voie adjacente. Dans ce mode de fonctionnement, le conducteur est capable de mieux percevoir l'environnement à courte distance s'il circule de nuit ou par des conditions météorologiques difficiles (brouillard, neige, pluie).

Le second mode de fonctionnement, couramment appelé « feu de route », produit un éclairage de forte intensité vers l'avant du véhicule et permet de considérablement accroître le champ de vision du conducteur, notamment de nuit et en cas de neige ou de pluie. En revanche, l'orientation du faisceau lumineux est susceptible dans ce cas d'éblouir des automobilistes circulant en sens inverse sur une voie adjacente ou circulant devant sur la même voie, c'est pourquoi il est nécessaire de basculer en feu de croisement dès que cette situation se présente.

Il est également connu de prévoir un mode de fonctionnement supplémentaire du projecteur dit ADB (d'après le sigle anglais pour *Adaptive Driving Beam*) ou encore « faisceau sélectif » produisant un éclairage du type « feu de route » partiellement masqué pour éviter l'éclairage de zones où sont présents des véhicules venant en sens inverse ou des véhicules roulant devant. On évite ainsi l'éblouissement des autres conducteurs tout en conservant un grand champ de vision. On pourra se référer au document EP-2 415 638 pour plus de précisions sur le mode de fonctionnement ADB.

Dans ce dernier mode de fonctionnement, le « faisceau sélectif » est produit par projection d'une image lumineuse formée par balayage d'un rayonnement lumineux.

Pour obtenir une image de taille satisfaisante, il faut réaliser le balayage sur un secteur angulaire soit d'angle important soit de rayon important. Dans ce dernier cas (rayon important) le trajet optique est relativement long si bien que les moyens pour réaliser l'image à projeter sont relativement encombrants. Au vu des contraintes d'encombrement de plus en plus sévères à l'avant d'un véhicule, on préfère donc retenir de réaliser le balayage sur un secteur angulaire d'angle important, plutôt que de rayon important. Le balayage doit donc couvrir un secteur angulaire qui soit suffisamment grand, par exemple de l'ordre de 15°, afin de créer une image lumineuse suffisamment grande.

On connaît déjà dans l'état de la technique des dispositifs de déviation de faisceau lumineux. Toutefois, ces dispositifs ne peuvent dévier un faisceau au maximum que de 2°.

Le document EP-2 690 352 propose de remédier à ce problème au moyen d'un système de balayage comportant des micro-miroirs articulés capables de balayer un faisceau lumineux sur un secteur angulaire satisfaisant.

Cependant, ce système soulève plusieurs problèmes.

En effet, les micro-miroirs sont fragiles mécaniquement car ils sont soumis à des vibrations et à des chocs pouvant dérégler leurs axes d'articulation voire les briser. De plus, ils sont fragiles thermiquement car leur coefficient de réflexion n'est pas strictement égal à 100% (il est généralement de l'ordre de 90 à 99%). Les micro-miroirs doivent donc absorber une partie de l'énergie transportée par le faisceau lumineux et leur faible capacité thermique (qu'implique leur faible volume) engendre par conséquent une élévation de température non négligeable pouvant les détériorer.

Par ailleurs, du fait que les miroirs parcourent des micro-déplacements, ils sont soumis à des contraintes de fatigue les détériorant progressivement.

Enfin, la commande d'un tel système à micro-miroirs est relativement complexe.

L'invention a pour but de fournir un système d'éclairage muni de moyens de balayage formant une image destinée à être projetée, ces moyens de balayage couvrant un secteur angulaire suffisamment important, et ce avec des moyens simples et robustes.

A cet effet, on prévoit selon l'invention un système d'éclairage pour véhicule automobile, comprenant
- une source de lumière apte à produire un faisceau lumineux, et
- des moyens pour balayer le faisceau lumineux comportant au moins un corps réfléchissant oscillant pour la déviation de la trajectoire du faisceau,
caractérisé en ce que le corps réfléchissant oscillant est manoeuvré par les déformations d'un organe de manoeuvre piézoélectrique, les moyens pour balayer le faisceau lumineux comportant de plus des moyens optiques d'amplification de la déviation de la trajectoire du faisceau lumineux, placés en aval du corps réfléchissant en considérant le sens de propagation du faisceau lumineux.

Ainsi, les moyens pour balayer le faisceau lumineux permettent de couvrir un secteur angulaire de l'ordre de 2°, et les moyens optiques d'amplification permettent de l'amplifier afin d'atteindre un angle de secteur angulaire satisfaisant. Les éléments participant à la déviation du faisceau lumineux étant le corps réfléchissant oscillant, l'organe de manoeuvre piézoélectrique et les moyens optiques d'amplification, on comprend bien que ce système d'éclairage est plus robuste et de conception plus simple que celui de l'art antérieur comprenant des micro-miroirs.

Avantageusement, le corps réfléchissant oscillant est une lame métallique.

Les métaux présentant généralement un coefficient de réflexion proche de 1, la lame n'absorbe qu'une infime partie de la puissance du faisceau lumineux. De plus, la lame métallique est massive, contrairement aux micro-miroirs de l'art antérieur, et est ainsi capable de dissiper efficacement le peu d'énergie transmise par le faisceau lumineux.

Avantageusement, le corps réfléchissant oscillant forme un levier, ce dernier étant manoeuvré par les déformations de l'organe de manoeuvre piézoélectrique.

Un levier est, comme on le sait, une machine simple particulièrement facile à manoeuvrer.

De préférence, le corps réfléchissant forme un levier du troisième genre, l'organe de manoeuvre agissant sur une partie de manoeuvre du levier intercalée entre une première extrémité d'articulation du levier et une seconde extrémité libre du levier, la première extrémité d'articulation étant de préférence formée par une extrémité fixe du levier apte à fléchir élastiquement.

On comprend ici que l'effort généré par la partie de manoeuvre peut résulter en un glissement de cette partie de manoeuvre sur le levier, de sorte que le levier forme alors un levier d'un autre genre, notamment du deuxième genre.

On peut ainsi aisément agencer l'organe de manoeuvre par rapport au corps réfléchissant.

Selon un mode de réalisation, les moyens optiques d'amplification de la déviation de la trajectoire du faisceau lumineux comprennent un miroir convexe, par exemple cylindrique ou sphérique.

Selon un autre mode de réalisation, les moyens optiques d'amplification de la déviation de la trajectoire du faisceau lumineux comprennent une lentille, préférentiellement divergente.

Ces moyens optiques permettent d'amplifier simplement et efficacement le balayage du faisceau lumineux par le corps réfléchissant oscillant afin d'atteindre un angle de secteur angulaire satisfaisant.

Avantageusement, le système d'éclairage comprend de plus des moyens d'absorption du faisceau lumineux destinés à absorber le faisceau lumineux lorsque le corps réfléchissant oscillant est dans une position prédéterminée de repos.

On prévoit également selon l'invention un procédé de mise en sécurité d'un système d'éclairage, caractérisé en ce que le système d'éclairage est tel que défini plus haut et en ce que, lorsque l'organe de manoeuvre piézoélectrique est désactivé, on place le corps réfléchissant oscillant dans sa position de repos.

Ainsi, lorsque le corps réfléchissant oscillant est dans sa position de repos, les moyens d'absorption absorbent le faisceau lumineux de manière à éviter la détérioration du système d'éclairage par échauffement.

Avantageusement, le système d'éclairage comprend en outre des premiers moyens de pilotage des déformations de l'organe de manoeuvre piézoélectrique et des seconds moyens de pilotage de la source de lumière.

On prévoit également selon l'invention un procédé de mise en sécurité d'un système d'éclairage caractérisé en ce que le système d'éclairage est tel que défini plus haut et en ce que, lorsque les premiers moyens de pilotage sont désactivés, on désactive la source de lumière à l'aide des seconds moyens de pilotage.

On évite ainsi la détérioration du système d'éclairage par échauffement au cas notamment où les premiers moyens de pilotage sont désactivés de façon intempestive.

L'invention sera mieux comprise à la lecture de la description qui va suivre donnée uniquement à titre d'exemple et faite en référence aux dessins dans lesquels :
- la figure 1 est une vue schématique du système d'éclairage selon l'invention,
- la figure 2 est une vue simplifiée du système d'éclairage de la figure 1 illustrant le balayage du faisceau lumineux se propageant dans le système d'éclairage,
- la figure 3 est une vue à plus grande échelle du corps réfléchissant du système d'éclairage de la figure 1, et
- la figure 4 est une vue à plus grande échelle des moyens d'absorption du système d'éclairage de la figure 1.

On rappelle qu'un levier est une machine simple dont on distingue généralement trois genres.

Un levier est dit du premier genre, ou intermobile, lorsque l'axe d'articulation de ce levier (point d'appui) est placé entre, d'une part, une partie de manoeuvre de ce levier, sur laquelle est appliquée une force de manoeuvre du levier (ou puissance), et, d'autre part, une partie active de ce levier sur laquelle est exercée une force de résistance.

Un levier est dit du deuxième genre, ou interrésistant, lorsque la partie active de ce levier est placée entre l'axe d'articulation et la partie de manoeuvre du levier.

Enfin, un levier est dit du troisième genre, ou interpuissant, lorsque la partie de manoeuvre de ce levier est placée entre l'axe d'articulation et la partie active de ce levier.

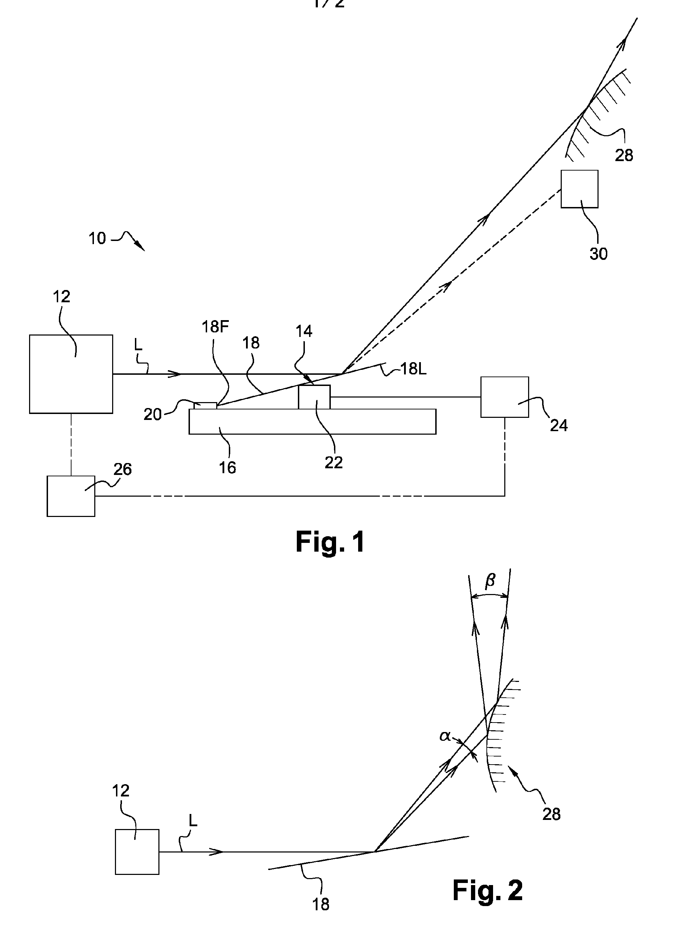

En référence à la figure 1, un système d'éclairage 10 pour véhicule automobile comprend une source de lumière 12 classique. Celle-ci comporte par exemple une diode laser (non représentée) émettant un faisceau lumineux sensiblement monochromatique L.

Des moyens 14 pour balayer le faisceau lumineux sont placés sur la trajectoire du faisceau lumineux L. Ces moyens de balayage 14 comprennent un support fixe 16, solidaire d'autres éléments optiques du système d'éclairage 10, notamment de la source de lumière 12, et un corps réfléchissant oscillant 18 fixé à ce support 16. L'inclinaison du corps réfléchissant 18 permet la déviation du faisceau lumineux L. Le corps réfléchissant 18 est ici formé par une lame métallique, dont le coefficient de réflexion est proche de 1, de manière à ce que la déperdition de puissance optique du faisceau lumineux L par absorption dans la lame soit la plus faible possible. Le corps réfléchissant 18 est fixé au support fixe 16 au moyen d'une soudure 20 effectuée à une extrémité 18F du corps réfléchissant. L'autre extrémité 18L du corps réfléchissant est libre.

Les moyens de balayage 14 comprennent également un organe de manoeuvre piézoélectrique 22 placé entre le support fixe 16 et le corps réfléchissant 18. Dans l'exemple décrit, le corps réfléchissant 18 forme un levier destiné à être manoeuvré par les déformations de l'organe de manoeuvre piézoélectrique 22. Plus particulièrement, le corps réfléchissant 18 forme un levier du troisième genre, l'organe de manoeuvre 22 agissant sur une partie de manoeuvre du levier intercalée entre une première extrémité d'articulation du levier et une seconde extrémité libre du levier. La première extrémité d'articulation est formée par l'extrémité soudée 18F du levier soudée au support au moyen de la soudure 20. Cette extrémité fixe 18F est apte à fléchir élastiquement.

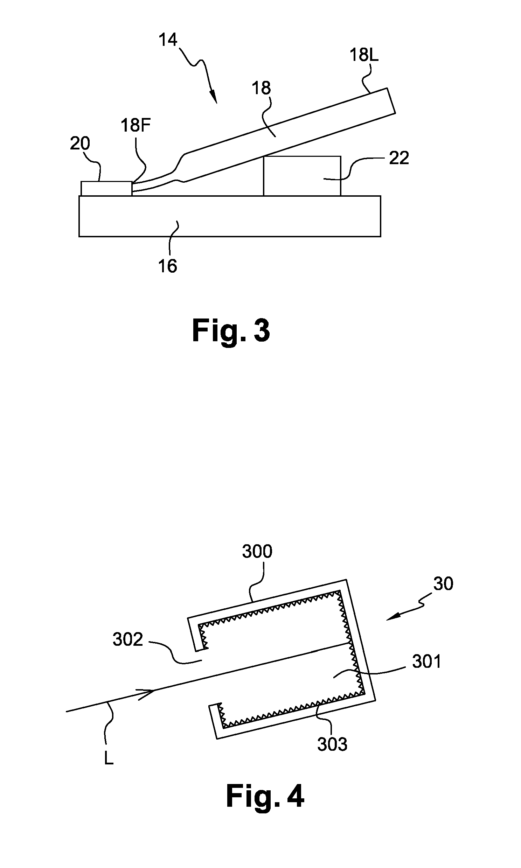

En référence à la figure 3, la lame métallique formant le corps réfléchissant 18 présente localement une faible épaisseur à proximité de son extrémité fixe 18F, par exemple sur 10% de la distance séparant les extrémités 18F et 18L, de manière à faciliter le fléchissement du corps réfléchissant par les déformations de l'organe de manoeuvre piézoélectrique 22. Au contraire, le reste de la lame métallique présente une épaisseur suffisamment grande, par exemple supérieure à 1 mm, de manière à ce que les déformations de l'organe de manoeuvre piézoélectrique 22 ne déforment pas une surface de réflexion du corps réfléchissant 18 destinée à dévier le faisceau lumineux L. Cette surface de réflexion reste ainsi sensiblement plane, bien que la lame métallique elle-même fléchisse.

Des premiers moyens de pilotage 24 sont connectés à l'organe de manoeuvre piézoélectrique 22. Ces premiers moyens 24 permettent de piloter le courant délivré à l'organe de manoeuvre piézoélectrique 22 par une source d'alimentation (non représentée), par exemple la batterie du véhicule dans lequel est monté le système d'éclairage 10.

Lorsque l'organe de manoeuvre piézoélectrique 22 est désactivé, c'est-à-dire lorsque les premiers moyens de pilotage 24 pilotent la délivrance d'un courant nul à l'organe de manoeuvre piézoélectrique 22, le corps réfléchissant oscillant 18 occupe une position prédéterminée dite de repos.

Des seconds moyens de pilotage 26 sont connectés à la source de lumière 12 et aux premiers moyens de pilotage 24. Lorsque ces derniers sont désactivés, de sorte que le corps réfléchissant 18 occupe sa position de repos, les seconds moyens de pilotage 26 détectent cette mise en position de repos et désactivent la source de lumière 12. Le système d'éclairage 10 est ainsi mis en sécurité.

Des moyens optiques 28 d'amplification de la déviation de la trajectoire du faisceau lumineux L sont placés en aval des moyens de balayage 14 en considérant le sens de propagation du faisceau lumineux. Ces moyens optiques 28 d'amplification sont ici formés par un miroir convexe cylindrique, mais on peut prévoir, en variante, qu'ils soient formés par un miroir convexe sphérique ou bien par une lentille, préférentiellement divergente. Ces moyens permettent de dévier une seconde fois le faisceau lumineux émis par la source de lumière 12. A titre d'exemple de réalisation, le miroir cylindrique peut avoir un rayon de courbure de 25 millimètres. On verra dans la suite que les propriétés géométriques des moyens optiques 28 d'amplification sont intéressantes pour l'utilisation qui en est faite.

Des moyens classiques d'absorption 30 sont placés sur le trajet optique du faisceau lumineux L, en aval des moyens de balayage 14 en considérant le sens de propagation du faisceau lumineux. Ces moyens d'absorption 30 sont positionnés de façon à absorber le faisceau lumineux lorsque le corps réfléchissant 18 est dans sa position de repos, le faisceau lumineux ne rencontrant pas les moyens d'absorption 30 lorsque les premiers moyens de pilotage 24 pilotent la déformation de l'organe de manoeuvre 22. On évite ainsi tout risque de détérioration, causée par exemple par un échauffement des éléments du système d'éclairage en cas de défaillance des premiers moyens de pilotage 24 et d'exposition prolongée de ces éléments au faisceau lumineux.

A titre d'exemple de réalisation, et en référence à la figure 4, ces moyens d'absorption 30 comportent une boîte 300 présentant une cavité 301 et une ouverture 302. Des parois de la cavité sont couvertes d'un revêtement absorbant 303, par exemple une peinture noire mate diffusante ou une anodisation. Lorsque le corps réfléchissant 18 est dans sa position de repos, le rayon L entre dans la cavité par l'ouverture 302. Il impacte la paroi du fond de la boîte 300 et est essentiellement absorbé par le revêtement 303. La faible proportion de lumière réfléchie est diffusée dans la boîte 300 ou elle est elle-même essentiellement absorbée par le revêtement absorbant 303. Seule une infime proportion de la lumière est susceptible de ressortir par l'ouverture 302.

On va maintenant décrire le fonctionnement du système d'éclairage 10.

La source de lumière 12 émet un faisceau lumineux monochromatique L en direction des moyens pour balayer le faisceau lumineux 14. En particulier, le faisceau L est réfléchi par le corps réfléchissant 18. Les premiers moyens de pilotage 24 pilotent l'organe de manoeuvre piézoélectrique 22 pour y engendrer une déformation oscillante. En se déformant ainsi, l'organe 22 manoeuvre le corps réfléchissant 18 formant levier de manière à ce que ce dernier oscille également et provoque le balayage du faisceau lumineux.

En référence à la figure 2, le faisceau lumineux L est balayé dans un premier secteur angulaire α non nul par réflexion sur l'organe réfléchissant 18 formant levier qui est soumis à des flexions causées par la déformation de l'organe de manoeuvre piézoélectrique 22. A titre d'exemple de réalisation, en utilisant un organe de manoeuvre piézoélectrique classique et des moyens de pilotage classiques, l'angle α du premier secteur angulaire est de l'ordre de 1,5°.

Le faisceau lumineux se propage ensuite jusqu'au miroir cylindrique 28. La courbure de ce dernier a pour effet d'amplifier la déviation faisceau, qui est alors balayé sur un second secteur angulaire β. Avec un miroir cylindrique de rayon de courbure de 25 millimètres et une distance traversée par le faisceau lumineux L entre le corps réfléchissant 18 en position de repos et le miroir cylindrique 28 de l'ordre de 35 millimètres, l'angle β du second secteur angulaire est de l'ordre de 15°.

Le faisceau lumineux se propage ensuite jusqu'à un dispositif de conversion de longueur d'onde (non représenté) connu en soi, comprenant par exemple du phosphore. Ce dernier forme alors une image lumineuse blanche résultant du balayage du faisceau lumineux monochromatique. L'image lumineuse est ensuite projetée par des moyens de projection (non représentés) connus en soi de manière à émettre la lumière vers un espace à éclairer.

Pour assurer la sécurité du système d'éclairage à l'égard notamment d'incidents de fonctionnement imprévisibles, lorsque l'organe de manoeuvre piézoélectrique 22 est désactivé, on place le corps réfléchissant oscillant 18 dans sa position de repos, ou lorsque les premiers moyens de pilotage 24 sont désactivés, on désactive la source de lumière 12 à l'aide des seconds moyens de pilotage 26.

Bien entendu, on pourra apporter à l'invention de nombreuses modifications sans sortir du cadre de celle-ci.

On peut prévoir que le pilotage du faisceau lumineux comprenne une boucle de rétroaction de manière à fiabiliser le fonctionnement du système d'éclairage.

On peut prévoir que les moyens optiques d'amplification de la déviation de la trajectoire du faisceau lumineux comprennent un miroir concave qui aura l'avantage de renverser les images par exemple entre la droite et la gauche du faisceau.

On peut encore prévoir d'utiliser un même programme de pilotage des premiers moyens de pilotage pour un projecteur gauche et pour un projecteur droit du véhicule automobile.

On peut prévoir que les moyens d'absorption sont simplement constitués d'une paroi recouverte d'une peinture mate de couleur noire.

## Revendications

1. Système d'éclairage (10) pour véhicule automobile, comprenant
- une source de lumière (12) apte à produire un faisceau lumineux (L), et
- des moyens (14) pour balayer le faisceau lumineux comportant au moins un corps réfléchissant oscillant (18) pour la déviation de la trajectoire du faisceau,
**caractérisé en ce que** le corps réfléchissant oscillant (18) est manoeuvré par les déformations d'un organe de manoeuvre piézoélectrique (22), les moyens (24) pour balayer le faisceau lumineux comportant de plus des moyens optiques (28) d'amplification de la déviation de la trajectoire du faisceau lumineux, placés en aval du corps réfléchissant (18) en considérant le sens de propagation du faisceau lumineux.

2. Système d'éclairage selon la revendication 1, dans lequel le corps réfléchissant oscillant (18) est une lame métallique.

3. Système d'éclairage selon la revendication 1 ou 2, dans lequel le corps réfléchissant oscillant (18) forme un levier, ce dernier étant manoeuvré par les déformations de l'organe de manoeuvre piézoélectrique (22).

4. Système d'éclairage selon la revendication 3, dans lequel le corps réfléchissant (18) forme un levier du troisième genre, l'organe de manoeuvre (22) agissant sur une partie de manoeuvre du levier intercalée entre une première extrémité (18F) d'articulation du levier et une seconde extrémité libre (18L) du levier, la première extrémité d'articulation (18F) étant de préférence formée par une extrémité fixe du levier apte à fléchir élastiquement.

5. Système d'éclairage selon l'une quelconque des revendications 1 à 4, dans lequel les moyens optiques (28) d'amplification de la déviation de la trajectoire du faisceau lumineux comprennent un miroir convexe, par exemple cylindrique ou sphérique.

6. Système d'éclairage selon l'une quelconque des revendications 1 à 4, dans lequel les moyens optiques (28) d'amplification de la déviation de la trajectoire du faisceau lumineux comprennent une lentille, préférentiellement divergente.

7. Système d'éclairage selon l'une quelconque des revendications 1 à 6, comprenant de plus des moyens (30) d'absorption du faisceau lumineux destinés à absorber le faisceau lumineux lorsque le corps réfléchissant oscillant est dans une position prédéterminée de repos.

8. Procédé de mise en sécurité d'un système d'éclairage, **caractérisé en ce que** le système d'éclairage est selon la revendication 7, et **en ce que**, lorsque l'organe de manoeuvre piézoélectrique (22) est désactivé, on place le corps réfléchissant oscillant (18) dans sa position de repos.

9. Système d'éclairage selon l'une quelconque des revendications 1 à 7, comprenant en outre des premiers moyens de pilotage (24) des déformations de l'organe de manoeuvre piézoélectrique et des seconds moyens (26) de pilotage de la source de lumière (12).

10. Procédé de mise en sécurité d'un système d'éclairage **caractérisé en ce que** le système d'éclairage est selon la revendication 9, et **en ce que**, lorsque les premiers moyens de pilotage (24) sont désactivés, on désactive la source de lumière (12) à l'aide des seconds moyens de pilotage (26).
